Europäisches Patentamt

European Patent Office

Office européen des brevets

(11) Numéro de publication: **0 376 828 B1**

(12) **FASCICULE DE BREVET EUROPEEN**

(45) Date de publication de fascicule du brevet: **13.04.94** (51) Int. Cl.⁵: **H03M 1/14**, H03M 1/16

(21) Numéro de dépôt: **89403627.6**

(22) Date de dépôt: **22.12.89**

(54) Circuit soustracteur-amplificateur pour convertisseur analogique numérique à cascade.

(30) Priorité: **30.12.88 FR 8817490**

(43) Date de publication de la demande:
**04.07.90 Bulletin 90/27**

(45) Mention de la délivrance du brevet:
**13.04.94 Bulletin 94/15**

(84) Etats contractants désignés:
**DE FR GB NL**

(56) Documents cités:
**FR-A- 2 189 938**

(73) Titulaire: **THOMSON-CSF SEMICONDUCTEURS SPECIFIOUES**
**173, Boulevard Haussmann**
**F-75008 Paris(FR)**

(72) Inventeur: **Tung, Pham Ngu**
**THOMSON-CSF**
**SCPI-CEDEX 67**
**F-92045 Paris La Defense(FR)**

(74) Mandataire: **Taboureau, James et al**
**THOMSON-CSF,**
**SCPI,**
**B.P. 329,**
**50, rue Jean-Pierre Timbaud**
**F-92402 Courbevoie Cédex (FR)**

Rank Xerox (UK) Business Services
(3.10/3.09/3.3.3)

EP 0 376 828 B1

**Description**

La présente invention concerne un circuit soustracteur amplificateur, incorporé dans un convertisseur analogique numérique à fractionnement. Ce circuit permet de convertir un signal électrique analogique en un signal numérique de grande précision, avec un grand nombre de bits, malgré la limitation que représente le pouvoir de résolution du convertisseur analogique-numérique (CAN).

Dans tous les convertisseurs connus, quel que soit leur principe, le signal analogique d'entrée est "pesé" par comparaison avec des signaux de "poids" connus. Plus on désire de précision dans la conversion, c'est-à-dire plus on désire de bits en sortie, plus faible est l'intervalle - constant - entre les poids. Il arrive une limite pour laquelle l'Intervalle, qui représente la sensibilité ou le pouvoir de résolution du CAN, est inférieur à la tension de basculement des transistors qui composent les circuits de mesure.

Pour franchir cette limite, les CAN à fractionnement, qui sont connus, isolent la partie du signal analogique qui est inférieure à la tension de basculement, l'amplifient, et délivrent les bits de poids inférieurs, avec une précision qu'il n'aurait pas été possible d'atteindre autrement. Ce schéma de fonctionnement est celui du convertisseur décrit dans le document FR-A-2 189 938, mais le détail de la réalisation du circuit soustracteur et de l'amplificateur, qui sont séparés, est différent et essentiellement orienté vers une plus grande rapidité de conversion plutôt que vers une plus grande précision de la conversion. A l'époque où ce document a été publié, les transistors silicium complémentaires n'étaient pas très rapides mais jouissaient d'une bonne précision, par suite d'une faible dispersion en fabrication. Avec les transistors actuels en GaAs ou autres matériaux du groupe III-V, qui jouissent d'une vitesse de travail élevé, le problème est transposé car leur dispersion en fabrication est dans certains cas supérieure à la précision exigée pour la conversion.

L'invention concerne le circuit qui permet d'isoler cette fraction inférieure du signal analogique et de la convertir en signaux binaires. Selon l'invention, le signal analogique d'entrée est adressé en parallèle à un premier CAN et à un circuit soustracteur-amplificateur. Ce premier CAN délivre tous les bits de poids supérieurs pour lesquels il n'y a pas de problème de sensibilité des transistors. Mais simultanément, ces bits sont adressés au soustracteur dans lequel, reconvertis en signal analogique, ils sont comparés au signal analogique d'entrée : la différence est un petit signal qui est amplifié de façon à permettre sa conversion en numérique par un second CAN, qui délivre les bits de poids inférieurs.

Le soustracteur-amplificateur est constitué par deux transistors en parallèle, dont le drain commun est alimenté par une source de courant modulable. La source de courant modulable est constituée, d'une part, par le courant correspondant au signal d'entrée, et d'autre part par le courant correspondant aux bits de sortie du premier CAN qui sont reconvertis en analogique. Ces deux courants sont soustraits par les deux transistors en parallèle, dont le second a un gain supérieur au premier, ce qui assure l'amplification. La sortie du soustracteur-amplificateur se fait au moyen d'un stabilisateur de tension de sortie. Le signal de sortie est adressé à un second CAN, qui délivre les bits de poids inférieurs.

De façon plus précise, l'invention concerne un circuit soustracteur-amplificateur, pour un convertisseur analogique-numérique transformant un signal analogique d'entrée en un signal numérique à N bits, et comportant deux CAN en cascade dont le premier délivre les bits de poids supérieur $N_1$ et le second délivre les bits de poids inférieur $N_2$ du signal à N bits, ce circuit étant caractérisé en ce qu'il comporte :
- montés en parallèle un transistor d'entrée qui transforme le signal analogique d'entrée, appliqué sur sa grille en un courant proportionnel à $N = N_1 + N_2$ et un transistor amplificateur, ces transistors étant linéaires, ayant mêmes tensions de seuils $V_T$ négatives, la pente ou transconductance G du transistor d'entrée étant égale à $2^j$ fois la pente du transistor amplificateur, j étant l'ordre du premier des bits de poids supérieur en comptant les bits à partir de zéro : $G_E = 2^j G_A$, ces transistors étant alimentés par une source de courant modulable fournissant un courant de charge, connectée sur leurs drains et constituée par :
- en premier lieu une charge active
- en second lieu un convertisseur numérique-analogique en parallèle avec la charge active, qui retransforme les bits de poids supérieur $N_1$, issus du premier CAN en un courant proportionnel à $N_1$, le courant qui traverse le transistor amplificateur étant égal à la différence entre le courant modulable de charge et le courant qui traverse le transistor d'entrée, donc proportionnel à $N_2$, le signal prélevé sur le drain du transistor amplificateur étant appliqué sur la grille du même transistor amplificateur via un circuit de stabilisation, la tension présente sur cette grille constituant le signal de sortie du soustracteur-amplificateur.

L'invention sera mieux comprise par la description détaillée qui suit maintenant d'un exemple de réalisation, cette description s'appuyant sur les figures jointes en annexe, qui représentent :

2

- figure 1 : schéma en diagramme de blocs d'un CAN à fractionnement utilisant le circuit soustracteur-amplicateur selon l'invention,
- figure 2 : schéma électrique du soustracteur-amplicateur selon l'invention,
- figure 3 : schéma électrique du premier CAN et du soustracteur-amplicateur selon l'invention.

De façon à rendre la description plus claire et plus précise, l'invention sera exposée en s'appuyant sur l'exemple d'un CAN à 8 bits, réalisé avec des transistors linéaires de type TEGFET, en arséniure de gallium, dont la dispersion technologique est de l'ordre de 20 à 30 mV, ce qui rend pratiquement impossible la réalisation directe de CAN de résolution 10 mV par exemple. Mais ces précisions ne limitent nullement la portée de l'invention : elles ne sont retenues que pour la clarté.

Soit $V_E$ un signal analogique d'entrée. Si $v_o$ est la sensibilité ou le pouvoir de résolution d'un CAN classique, on peut poser :

$$V_E = Nv_o$$

Un CAN classique de 8 bits, ayant donc 8 sorties $S_i$ numérotées de 0 à 7, peut mesurer $V_E$ en 255 intervalles de valeur $v_o$, et en donner en sortie un nombre binaire représentant le nombre N

$$N = \sum_o^7 S_i . 2^i$$

Le premier bit est noté 0 parce que $2^0 = 1$
En prenant les 4 bits supérieurs, on obtient un nombre

$$N_1 = {\sum_4'}^7 S_j . 2^j$$

$$= S_7 . 2^7 + S_6 2^6 + S_5 . 2^5 + S_4 . 2^4$$

$$= 16(S_7 . 2^3 + S_6 . 2^2 + S_5 . 2 + S_4)$$

Le nombre $N_1$ est mesuré par un CAN de 4 bits dont le pouvoir de résolution 16 $v_o$ est 16 fois supérieur à celui du CAN de 8 bits.

Technologiquement, il est beaucoup plus facile de réaliser un CAN de 4 bits de pouvoir de résolution 16 $v_o$ qu'un CAN de 8 bits de pouvoir de résolution $v_o$. Mais il faut compléter le nombre $N_1$ au moyen d'un circuit soustracteur permettant de mesurer :

$$V_S = V_E - N_1 v_o$$

et de l'amplifier par 16 :

$$V'_S = 16 V_S$$

Comme par définition $V_E = Nv_o$

$$V_S = (N - N_1) v_o = \Sigma_o^3 S_k . 2^k . v_o$$
$$V'_S = 16 V_S = 16 v_o \Sigma_o^3 S_k . 2^k = 16 v_o N_2$$

Le signal $V'_S$ peut être mesuré par un deuxième CAN de 4 bits de sensibilité $16v_o$ dont la sortie représente le complément $N_2$ du nombre N à déterminer :

$$N = N_1 + N_2$$

Ainsi, deux CAN identiques, de 4 bits chacun et de sensibilité 16 $v_o$ chacun donnent $N_1$ et $N_2$ plus

EP 0 376 828 B1

facilement qu'un CAN unique de 8 bits et de sensibilité $v_o$.

En d'autres termes, pour numériser un signal analogique sur 8 bits avec une résolution de 10 mV, on ne sait pas réaliser un CAN 8 bits de 10 mV de sensibilité - à cause de la dispersion technologique de 20 à 30 mV -, mais on sait réaliser deux CAN 4 bits de 160 mV de sensibilité, qui donnent le même résultat.

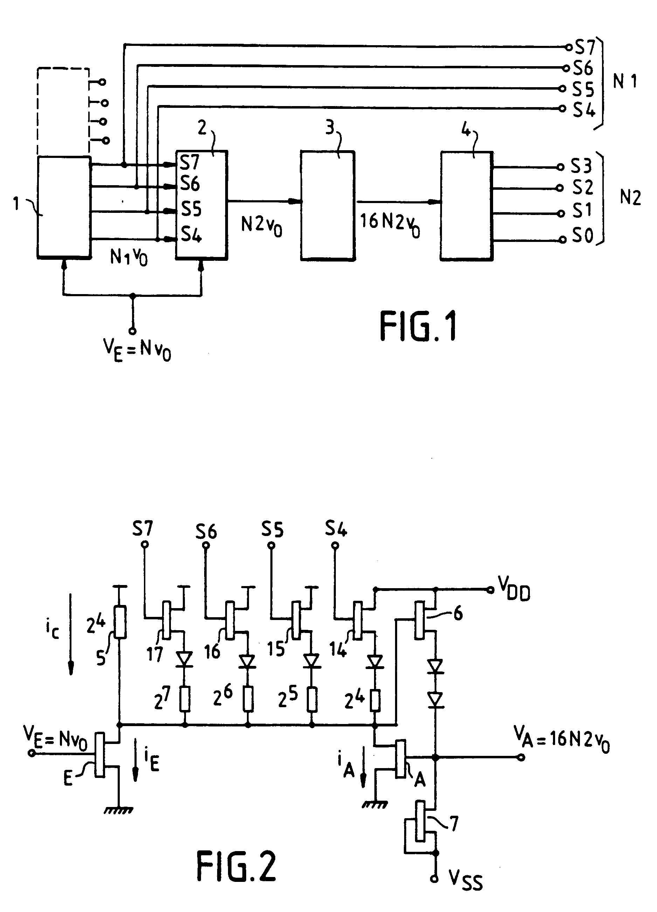

La figure 1 représente le schéma de blocs d'un CAN à cascade 8 bits utilisant le circuit soustracteur-amplificateur selon l'invention.

Le signal d'entrée $V_E = Nv_o$ est adressé simultanément à un premier CAN 4 bits repéré 1, et à un soustracteur 2. L'extension en pointillé du premier CAN est relative au cas où la numérisation serait effectuée sur 12, 16 bits ou plus : dans ce cas, toutes les sorties du CAN 1 sont adressées au soustracteur 2, pour en tirer $N_2 = N-N_1$

Le premier CAN 1 délivre les 4 bits de poids supérieurs $S_4$ à $S_7$, qui sont adressés simultanément sur la sortie du dispositif d'ensemble, et sur l'entrée du soustracteur 2. Ces 4 bits supérieurs mesurent les nombres $N_1$ de 16 à 240 par pas de 16 (240 + 16 = 256).

L'ensemble du soustracteur 2 et de l'amplificateur 3 constitue le soustracteur amplificateur qui est l'objet de l'invention et qui sera détaillé en figure 2.

Le signal analogique qui en sort, 16 $N_2v_o$ ou de façon plus générale K $N_2v_o$, est adressé à un second CAN 4, identique au premier CAN 1, qui délivre les 4 bits de poids inférieurs $S_o$ à $S_3$, qui mesurent les nombres de 0 à 15.

Le premier CAN 1 a, dans l'exemple choisi, un pouvoir de résolution de $16v_o$ : les signaux de valeur inférieure à $16v_o$ sont détectés par le soustracteur 2 qui compare le signal d'entrée $V_E = Nv_o$ avec le signal $N_1v_o$ obtenu par reconversion de 4 bits $S_4$ à $S_7$ en un signal analogique. La différence.

$$Nv_o - N_1v_o = N_2v_o$$

est amplifiée par un facteur 16 par l'amplificateur 3. Le signal amplifié $16N_2v_o$ est transformé par le second CAN 4, qui a même pouvoir de résolution $16v_o$ que le premier CAN, en un nombre binaire $N_2$ de 4 bits.

La figure 2 représente le schéma électrique du circuit soustracteur-amplificateur 2 + 3.

Il comprend un convertisseur numérique-analogique formé par les 4 transistors 14 à 17 et leurs charges. Les 4 bits (0 ou 1 logique) de poids supérieurs $S_4$ à $S_7$ (nombre $N_1$) sont appliqués sur les grilles des transistors interrupteurs 14 à 17, dont les sources sont chargées, à travers une diode Schottky, par une charge active, respectivement de valeurs $2^4$, $2^5$, $2^6$ et $2^7$. Ce convertisseur numérique-analogique (CNA) fournit donc un courant $N_1i_o$ ($i_o$ étant le courant correspondant à l'intervalle de tension $v_o$).

Il comprend en outre un transformateur tension-courant, formé par le transistor d'entrée E et une charge active 5, de valeur $2^4 = 16$. Le signal d'entrée $V_E = Nv_o$, appliqué sur la grille du transistor d'entrée E, est transformé en un courant $i_E = Ni_o$.

Enfin, en sortie, un transistor A amplificateur est réuni à un système de stabilisation de la tension de sortie $V_A$, composé d'un transistor suiveur 6 et de sa charge de rappel 7.

Bien entendu, tous ces transistors sont alimentés entre une tension $V_{DD}$ et la masse, ou entre $V_{DD}$ et $V_{SS}$ pour le circuit de stabilisation.

D'un point de vue technologique, les transistors E et A sont linéaires, de type TEGFET, à mêmes tensions de seuils $V_T$ négatives. Ils ont une pente ou transconductance G constante mais telle que

$$G_E = 16 G_A$$

Les transistors 6 et 7 du circuit de stabilisation sont à tensions de seuils négatives et les transistors interrupteurs 14 à 17 à tensions de seuils positives. Les charges actives sont des transistors dont la grille est reliée à la source : ce sont leurs dimensions qui font que ces charges actives débitent des courants en proportion $2^4i_o$, $2^5i_o$, $2^6i_o$ et $2^7i_o$.

Le courant de charge $i_c$ est commun aux deux transistors E et A :

$$i_c = i_E + i_A$$
$$i_c = 16i_o + N_1i_o$$
$$i_E = Ni_o = (N_1 + N_2)i_o = G_E(V_E - V_T)$$
$$i_A = i_C - i_E = (16 - N_2)i_o = G_A(V_A - V_T)$$

(la tension de seuil $V_T$ est la même pour les deux transistors E et A).

Si la variation $\Delta V_E$ du signal d'entrée ne dépasse pas $16v_o$, le CAN 1 ne change pas, et $i_c$ est constant.

4

$$G_E\Delta V_E + G_A\Delta V_A = 0$$

$$\triangle V_A = -\frac{G_E}{G_A}\triangle V_E$$

Mais on a choisi $G_E/G_A = 16$. De l'expression de $i_A$, on tire

$$V_A = (16 - N_2)\, 16\, v_o + V_T$$

On peut donc numériser $V_A$ au moyen d'un CAN 4, à 4 bits, de sensibilité $16\, v_o$, dont les sorties donnent un nombre binaire

$$M = 16 - N_2$$

Le nombre M est converti en nombre $N_2$ soit par des verseurs, soit en utilisant un CAN à cascade selon le brevet français enregistré sous le numéro FR-A- 2 623 034, du 10 novembre 1987, appartenant à la demanderesse, en utilisant les sorties complémentaires $S_o$ à $S_3$ de ce CAN

| $M = 16 - N2$ | $S_3$ | $S_2$ | $S_1$ | $S_0$ | $S_3$ | $S_2$ | $S_1$ | $S_0$ | $N_2$ |
|---|---|---|---|---|---|---|---|---|---|
| 16 | 1 | 1 | 1 | 1 | 0 | 0 | 0 | 0 | 0 |
| 15 | 1 | 1 | 1 | 0 | 0 | 0 | 0 | 1 | 1 |
| 14 | 1 | 1 | 0 | 1 | 0 | 0 | 1 | 0 | 2 |
| 13 | 1 | 1 | 0 | 0 | 0 | 0 | 1 | 1 | 3 |
| 12 | 1 | 0 | 1 | 1 | 0 | 1 | 0 | 0 | 4 |
| 11 | 1 | 0 | 1 | 0 | 0 | 1 | 0 | 1 | 5 |
| 10 | 1 | 0 | 0 | 1 | 0 | 1 | 1 | 0 | 6 |
| 9 | 1 | 0 | 0 | 0 | 0 | 1 | 1 | 1 | 7 |
| 8 | 0 | 1 | 1 | 1 | 1 | 0 | 0 | 0 | 8 |
| 7 | 0 | 1 | 1 | 0 | 1 | 0 | 0 | 1 | 9 |
| 6 | 0 | 1 | 0 | 1 | 1 | 0 | 1 | 0 | 10 |
| 5 | 0 | 1 | 0 | 0 | 1 | 0 | 1 | 1 | 11 |
| 4 | 0 | 0 | 1 | 1 | 1 | 1 | 0 | 0 | 12 |
| 3 | 0 | 0 | 1 | 0 | 1 | 1 | 0 | 1 | 13 |
| 2 | 0 | 0 | 0 | 1 | 1 | 1 | 1 | 0 | 14 |
| 1 | 0 | 0 | 0 | 0 | 1 | 1 | 1 | 1 | 15 |

L'étage de sortie à haute stabilité, constitué par les transistors A, 6, 7 et les diodes, est décrit dans le brevet français enregistré sous le numéro FR-A-2 623 350 du 17 novembre 1987, appartenant à la demanderesse.

Ainsi le CAN 8 bits de la figure 1 permet, grâce au soustracteur-amplificateur de l'invention, de numériser avec précision et facilité un signal analogique dont les bits de poids supérieurs sont donnés par un premier CAN et les bits de poids inférieurs par un deuxième CAN, les deux CAN ayant la même sensibilité, $16\, v_o$ en l'occurrence.

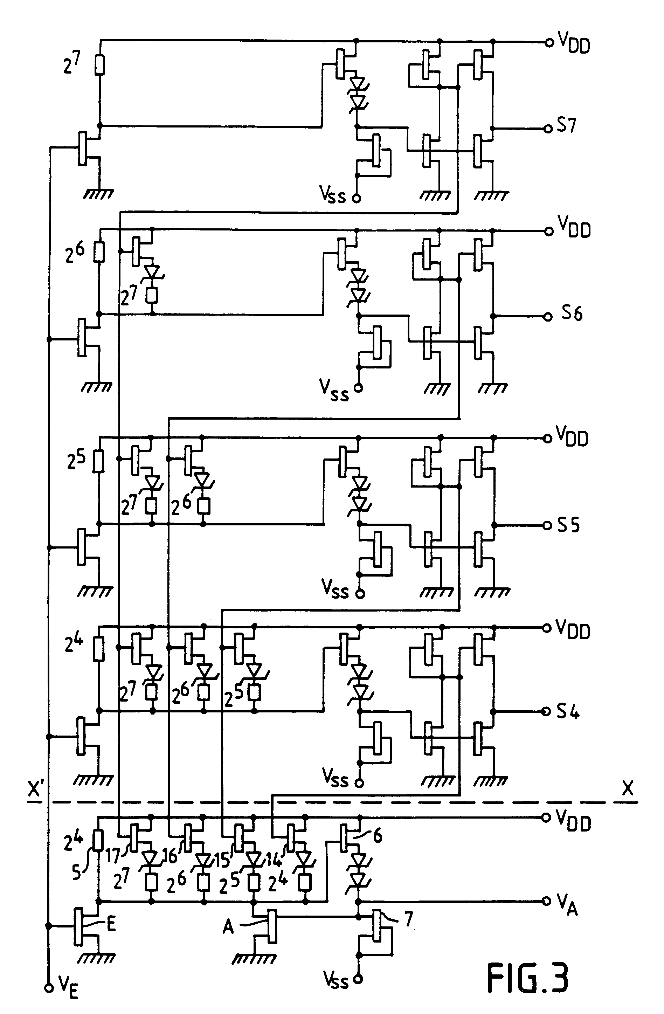

La figure 3 représente le schéma électrique du premier CAN et du soustracteur-amplificateur selon l'invention. Elle est coupée par une ligne pointillée X'X : au-dessus de X'X se trouve un CAN à cascade selon le brevet précité FR-A-2 623 034, qui délivre les bits de poids supérieurs $S_4$ à $S_7$. Au-dessous de X'X se trouve le soustracteur-amplificateur selon l'invention : le signal d'entrée $V_E$ lui est appliqué en parallèle avec le CAN 1, et il délivre un signal $V_A$ qui est à son tour appliqué à un second CAN 4 identique au premier.

Pour faciliter l'exposé, on a supposé que le CAN est à 8 bits, dont les 4 bits inférieurs sont plus aisément déterminés, grâce à l'invention (d'où le nombre 16 parce que 24 = 16). Mais la transposition est évidente pour l'homme de l'art, en fonction :
- du nombre de bits requis pour déterminer N,
- de la sensibilité $v_o$ requise pour chaque CAN 1 et 4,
- de la technologie utilisée, et donc de la dispersion sur la réalisation des transistors.

En particulier, si le nombre N est déterminé par i bits, en comptant les bits à partir de zéro, dont le bit d'ordre j est le premier des bits de poids supérieur, le gain du transistor d'entrée E est égal à $2^j$ fois le gain du transistor amplificateur A, et les charges actives sont en progression $2^j, 2^{j+1}...2^i$, pour le convertisseur numérique-analogique.

Le circuit selon l'invention peut être réalisé en silicium, mais pour obtenir des transistors E et A linéaires de pentes bien déterminées, il est préférable de le réaliser en arséniure de gallium, avec des TEGFETS.

**Revendications**

1. Circuit soustracteur-amplificateur, pour un convertisseur analogique-numérique - CAN - transformant un signal analogique d'entrée ($V_E$) en un signal numérique à N bits, et comportant deux CAN en cascade dont le premier (1) délivre les bits de poids supérieur $N_1$ et le second (4) délivre les bits de poids inférieur $N_2$ du signal à N bits, ce circuit étant caractérisé en ce qu'il comporte :
   - montés en parallèle, un transistor d'entrée (E) qui transforme le signal analogique d'entrée ($V_E$), appliqué sur sa grille en un courant ($i_E$) proportionnel à $N = N_1 + N_2$ et un transistor amplificateur (A), ces transistors étant linéaires, ayant mêmes tensions de seuils $V_T$ négatives, la pente ou transconductance G du transistor d'entrée (E) étant égale à $2^j$ fois la pente du transistor amplificateur (A), j étant l'ordre du premier des bits de poids supérieur en comptant les bits à partir de zéro : $G_E = 2^j G_A$, ces transistors étant alimentés par une source de courant modulable fournissant un courant de charge ($1_c$), connectée sur leurs drains et constituée par :
   - en premier lieu une charge active (5)
   - en second lieu un convertisseur numérique-analogique (14 à 17) en parallèle avec la charge active (5), qui retransforme les bits de poids supérieur $N_1$, issus du premier CAN (1) en un courant proportionnel à $N_1$, le courant ($i_A$) qui traverse le transistor amplificateur (A) étant égal à la différence entre le courant modulable de charge ($1_c$) et le courant (iE) qui traverse le transistor d'entrée (E), donc proportionnel à $N_2$, le signal prélevé sur le drain du transistor amplificateur (A) étant appliqué sur la grille du même transistor amplificateur (A) via un étage de stabilisation (6,7), la tension présente sur cette grille constituant le signal de sortie ($V_A$) du soustracteur-amplificateur.

2. Circuit soustracteur amplificateur selon la revendication 1, caractérisé en ce que la charge active (5) est proportionnelle à $2^j i_o$, $i_o$ étant le courant correspondant à la sensibilité $v_o$.

3. Circuit soustracteur amplificateur selon la revendication 2, caractérisé en ce que le convertisseur numérique-analogique est formé par une pluralité de transistors (14 à 17) en parallèle, dont les grilles sont commandées par les sorties logiques ($S_4$ à $S_7$) du premier CAN (1), et dont les sources sont chacune en série avec une diode et avec une charge, la pluralité des charges débitant des courants proportionnels à $2^j i_o, 2^{j+1} i_o, ... 2^i i_o$, i étant le nombre total de bits fournis par le CAN à cascade.

4. Circuit soustracteur amplificateur selon la revendication 1, caractérisé en ce que sa tension de sortie ($V_A$) est stabilisée par un étage comprenant un transistor suiveur (6) dont la source est montée en série avec une pluralité de diodes de décalage et avec un transistor de rappel (7), la tension de sortie ($V_A$) étant appliquée sur la grille du transistor amplificateur (A).

**Claims**

**1.** Subtracter/amplifier circuit for an analog/digital converter ADC transforming an input analog signal ($V_E$) into an N-bit digital signal and including two cascaded ADCs, the first (1) of which delivers the bits of higher significance $N_1$ and the second (4) of which delivers the bits of lower significance $N_2$ of the N-bit signal, this circuit being characterized in that it includes:
   - mounted in parallel, an input transistor (E) which transforms the input analog signal ($V_E$) applied to its grid into a current ($i_E$) proportional to $N = N_1 + N_2$ and an amplifier transistor (A), these transistors being linear and having the same negative threshold voltages $V_T$, the slope or transconductance G of the input transistor (E) being equal to $2^j$ times the slope of the amplifier transistor (A), j being the order of the first of the bits of higher significance when counting the bits from zero: $G_E = 2^j G_A$, these transistors being powered by an adjustable current source providing a load current ($i_c$), and which is connected to their drains and consists of:
   - firstly, an active load (5)
   - secondly, a digital/analog converter (14 to 17) in parallel with the active load (5), which retransforms the bits of higher significance $N_1$, coming from the first ADC (1), into a current proportional to $N_1$, the current ($i_A$) which crosses the amplifier transistor (A) being equal to the difference between the adjustable load current ($i_c$) and the current (iE) which crosses the input transistor (E), hence proportional to $N_2$, the signal extracted on the drain of the amplifier transistor (A) being applied to the grid of the same amplifier transistor (A) via a stabilizing stage (6, 7), the voltage present on this grid constituting the output signal ($V_A$) from the subtracter/amplifier.

**2.** Subtracter amplifier circuit according to Claim 1, characterized in that the active load (5) is proportional to $2^j i_0$, $i_0$ being the current corresponding to the sensitivity $V_0$.

**3.** Subtracter amplifier circuit according to Claim 2, characterized in that the digital/analog converter is formed from a plurality of transistors (14 to 17) in parallel, the grids of which are controlled by the logic outputs ($S_4$ to $S_7$) from the first ADC (1), and the sources of which are each in series with a diode and with a load, the plurality of loads drawing currents proportional to $2^j i_0$, $2^{j+1} i_0$, ... $2^i i_0$, i being the total number of bits supplied by the cascade ADC.

**4.** Subtracter amplifier circuit according to Claim 1, characterized in that its output voltage ($V_A$) is stabilized by a stage comprising a follower transistor (6) whose source is mounted in series with a plurality of shifter diodes and with a restoring transistor (7), the output voltage ($V_A$) being applied to the grid of the amplifier transistor (A).

**Patentansprüche**

**1.** Subtrahierverstärker für einen Analog-Digital-Wandler, der ein analoges Eingangssignal ($V_E$) in ein digitales Signal mit N Bits umwandelt und zwei Analog-Digital-Wandler in Kaskade enthält, von denen der erste (1) die Bits höheren Gewichts $N_1$ und der zweite (2) die Bits niedrigeren Gewichts $N_2$ des Signals mit N Bits liefert, dadurch gekennzeichnet, daß er in Parallelschaltung einen Eingangstransistor (E), der das an seine Gateelektrode angelegte analoge Eingangssignal ($V_E$) in einen Strom ($i_E$) proportional zu $N = N_1 + N_2$ transformiert, und einen Verstärkertransistor (A) aufweist, wobei die Transistoren linear sind und gleiche negative Schwellenspannungen ($V_T$) besitzen, wobei die Kennliniensteigung oder Transkonduktanz G des Eingangstransistors (E) gleich $2^j$ mal der Kennliniensteigung des Verstärkertransistors (A) ist und j die Rangordnung des ersten der Bits höheren Gewichts darstellt, indem die Bits von Null an gezählt werden: $G_E = 2^j G_A$, wobei diese Transistoren von einer modulierbaren Stromquelle gespeist werden, die einen Laststrom ($i_c$) liefert, an die Drainelektroden der Transistoren angeschlossen ist und besteht aus:
   - erstens einer aktiven Last (5),
   - zweitens einem Analog-Digital-Wandler (14 bis 17) parallel zur aktiven Last (5), die die Bits höheren Gewichts $N_1$, die aus dem ersten Analog-Digital-Wandler (1) kommen, in einen Strom proportional zu $N_1$ umwandeln, wobei der Strom ($i_A$), der den Verstärkertransistor (A) durchfließt, gleich der Differenz zwischen dem modulierbaren Laststrom ($i_c$) und dem Strom ($i_E$) ist, der den Eingangstransistor (E) durchfließt, und damit proportional zu $N_2$, wobei das am Drain des Verstärkertransistors (A) entnommene Signal an das Gate desselben Verstärkertransistors (A) über eine Stabilisationsstufe (6, 7) angeschlossen wird und die Spannung an diesem Gate das Ausgangssignal ($V_A$) des Subtrahierverstärkers bildet.

2. Subtrahierverstärker nach Anspruch 1, dadurch gekennzeichnet, daß die aktive Last (5) proportional zu $2^j i_o$ ist, wobei $i_o$ der Strom entsprechend der Empfindlichkeit $v_o$ ist.

3. Subtrahierverstärker nach Anspruch 2, dadurch gekennzeichnet, daß der Analog-Digital-Wandler aus einer Mehrzahl von Transistoren (14 bis 17) in Parallelschaltung gebildet wird, deren Gates von den logischen Ausgängen ($S_4$ bis $S_7$) des ersten Analog-Digital-Wandlers (1) gesteuert werden und deren Sourceelektroden je mit einer Diode und einer Last in Reihe liegen, wobei durch die Lastwiderstände Ströme proportional zu $2^j i_o$, $2^{j+1} i_o$, ... $2^i i_o$ fließen und i die Gesamtzahl von durch den Analog-Digital-Wandler in Kaskade gelieferten Bits ist.

4. Subtrahierverstärker nach Anspruch 1, dadurch gekennzeichnet, daß die Ausgangsspannung ($V_A$) durch eine Stufe stabilisiert wird, die einen Transistor (6) in Folgeschaltung enthält, dessen Sourceelektrode in Reihe mit einer Mehrzahl von Verschiebedioden und mit einem Rückholtransistor (7) geschaltet ist, wobei die Ausgangsspannung ($V_A$) an das Gate des Verstärkertransistors (A) angelegt wird.

FIG.1

FIG.2

FIG.3